# EUROPÄISCHE PATENTSCHRIFT

(11) **EP 0 751 541 B1**
(45) Veröffentlichungstag und Bekanntmachung des Hinweises auf die Patenterteilung: **12.12.2001**
(21) Anmeldenummer: 96108437.3
(22) Anmeldetag: 28.05.1996
(51) Int. Cl.: H01H 3/16

(54) **Justierbarer berührungsloser Pedalschalter**
Adjustable proximity switch actuated by a pedal
Interrupteur de proximité ajustable, commandé par une pédale

(30) Priorität: 30.06.1995 DE 29510700 U
(43) Veröffentlichungstag der Anmeldung: 02.01.1997
(73) Patentinhaber: TYCO Electronics Logistics AG, 9323 Steinach (CH)
(72) Erfinder: Jansseune, Luc, 8000 Brugge (BE); Meulemeester, Dmitri, 8820 Oostkamp (BE)
(74) Vertreter: Klunker . Schmitt-Nilson . Hirsch

(56) Entgegenhaltungen:
- DE-A- 3 625 057
- FR-A- 2 441 258
- FR-A- 2 532 105

## Beschreibung

Die Erfindung betrifft ein Pedal mit berührungslosem Pedalschalter.

Aus FR A 2 441 258 ist ein Pedalschalter bekannt, bei dem ein Pedal eine selbstjustierend angeordnete Stange axial verschiebt, wobei auf der Stange ein beweglicher Kontakt angeordnet ist. Dieser bewegliche Kontakt schließt bei Betätigung des Pedals den elektrischen Stromkreis für die Bremslichter eines Kraftfahrzeuges.

Es besteht gegenwärtig ein Trend, mindestens einige der bisher verwendeten mechanischen Schalter durch berührungslose Näherungsschalter zu ersetzen. Infrage kommen nach verschiedenen Funktionsprinzipien arbeitende Hall-Sensoren, aber auch induktive oder kapazitive Näherungsschalter. Wenn es beispielsweise um das zuverlässige Einschalten der Bremslichter bei Betätigen des Bremspedals eines Kraftfahrzeugs geht, ist der Einsatz der gegenüber mechanischen Schaltern schneller reagierenden kontaktlosen Näherungsschalter grundsätzlich sehr vorteilhaft. Problematisch ist jedoch, daß die Lagetoleranzen des Bremspedals, wie von Pedalen allgemein, im Ruhezustand sehr groß sind, so daß nicht ohne weiteres gewährleistet ist, daß der mit dem Pedal verbundene Auslösekörper im Ruhezustand des Pedals tatsächlich in den aktiven Schaltbereich des Näherungsschalters hineinreicht, bzw. diesen bei Betätigen des Pedals möglichst direkt und schnell wieder verläßt. Bisher waren deshalb aufwendige Justiermaßnahmen bei der Endmontage erforderlich.

Aufgabe der vorliegenden Erfindung ist es, einen mit geringem Aufwand herstellbaren und justierbaren berührungslosen Pedalschalter anzugeben.

Erfindungsgemäß wird dies erreicht durch ein Pedal mit berührungslosem Pedalschalter mit einem lagefest angeordneten Näherungsschalter und mit einem am Pedal im wesentlichen parallel zu dessen Betätigungsrichtung angeordneten, sich mit dem Pedal in axialer Richtung mitbewegenden ferromagnetischen Stift, dessen schalterseitiges Ende in der Ruhestellung des Pedals in den aktiven Schaltbereich des Näherungsschalters hineinreicht und durch Betätigen des Pedals aus dem Schaltbereich herausbewegbar ist, wobei der Stift im Pedal zum Zweck der Selbstjustage axial verschiebbar gelagert ist.

Weitere Ausgestaltungen der Erfindung sind in Unteransprüchen gekennzeichnet.

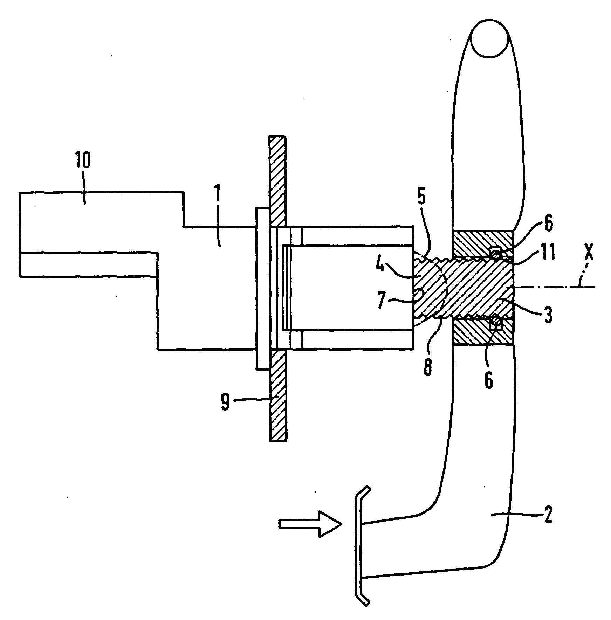

Im folgenden werden die Erfindung und ihre Vorteile anhand eines Ausführungsbeispiels und der einzigen Figur der Zeichnung, die in einer geschnittenen Seitenansicht schematisch einen berührungslosen Pedalschalter zeigt, näher erläutert.

Im linken Teil der Figur ist ein Näherungsschalter 1 , beispielsweise ein Bremslichtschalter, dargestellt, der mittels des Befestigungsbleches 9 beispielsweise im Fußraum eines Kfz befestigt ist. Der Bremslichtschalter kann über einen Steckerkragen 10 an die Autoelektrik angeschlossen sein. Pedalseitig weist der Näherungsschalter wie üblich eine aktive Fläche 7 und einen aktiven Schaltbereich 5 auf, der der aktiven Fläche 7 zugeordnet ist. Ein ferromagnetischer Auslösekörper muß mindestens teilweise in den kuppelförmigen Schaltbereich 5 hineinreichen, um den Schaltzustand des Näherungsschalters ändern zu können.

Im rechten Teil der Figur ist ein Bremspedal 2, beispielsweise aus Kunststoff oder Aluminium, dargestellt, das durch Fußdruck betätigt werden kann. Der ferromagnetische Stift 3 befindet sich im wesentlichen quer am Pedal 2, so daß er sich bei der durch einen Pfeil angedeuteten Betätigung des Pedals 2 mit diesem im wesentlichen in axialer Stiftrichtung, also längs der Achse X, mitbewegt. Befindet sich der Stift 3 in Ruhestellung im aktiven Schaltbereich 5 des Näherungsschalters 1, so ist dessen Ausgang in dieser Stellung beispielsweise low. Bei Betätigung des Bremspedals 2 wird der Stift 3 vom Näherungsschalter 1 abgehoben, (in der Figur nach rechts) aus dem aktiven Schaltbereich 5 herausbewegt und das Signal am Ausgang des Schalters schaltet um auf "aktiv". Dieses aktive Signal läßt die Steuerung der Bremslichter schalten.

Da die Lagetoleranzen des Bremspedals 2 im Ruhezustand sehr groß sind, wird der Stift 3 erfindungsgemäß selbstjustierend angeordnet. Der beispielsweise aus Stahl oder PBT-Eisen bestehende Stift 3 ist in einer Bohrung 11 im Pedal 2 gelagert. Eine Feder, beispielsweise eine sogenannte Omega-Feder 6, deren Form ungefähr der des griechischen Buchstaben Omega entspricht, drückt in radialer Richtung in eine V-Nut der Rändelung 8 des Stiftes 3. Dadurch wird der Stift 3 in axialer Richtung fixiert. Wenn eine axiale Kraft auf den Stift 3 ausgeübt wird, so werden die Federschenkel auseinanderbewegt und der Stift 3 wird so weit durchrasten, bis die Kraft weggenommen wird. In dieser neuen Position bleibt der Stift 3 und wird durch die Feder 6 wieder gehalten.

Bei der Montage des Bremspedals 2 wird der Stift 3 in einer zu weit in Richtung Näherungsschalter 1 vorstehenden Position fixiert. Das Pedal 2 wird in Ruhestellung bis auf Anschlag gezogen. Dadurch wird der Stift 3 gegen den Näherungsschalter 1 stoßen und so weit nach rechts verschoben, bis die Bewegung aufhört. Unabhängig von der ursprünglichen Toleranzlage zwischen Näherungsschalter 1 und Bremspedal 2 wird der Stift 3 dann immer in Ruhestellung auf der aktiven Fläche des Näherungsschalters anliegen, oder sich in dessen unmittelbarer Nähe befinden. Erfindungsgemäß ergibt sich dadurch ein sehr enger, nur etwa 2 mm oberhalb der aktiven Fläche liegender Schaltpunkt, also eine besonders hohe Reagibilität des Schalters. Erforderlich sind lediglich kostengünstige mechanische Teile, sowie ein sehr einfach durchführbarer Justiervorgang.

## Patentansprüche

1. Pedal mit berührungslosem Pedalschalter mit einem lagefest angeordneten Näherungsschalter (1) und mit einem am Pedal (2) im wesentlichen parallel zu dessen Betätigungsrichtung angeordneten, sich mit dem Pedal in axialer Richtung mitbewegenden ferromagnetischen Stift (3), dessen schalterseitiges Ende (4) in der Ruhestellung des Pedals (2) in den aktiven Schaltbereich (5) des Näherungsschalters (1) hineinreicht und durch Betätigen des Pedals (2) aus dem Schaltbereich (5) herausbewegbar ist, wobei der Stift (3) im Pedal (2) zum Zweck der Selbstjustage axial verschiebbar gelagert ist.

2. Pedal mit berührungslosem Pedalschalter nach Anspruch 1,
**dadurch gekennzeichnet, daß**
der Stift (3) soweit verschoben und justiert ist, daß sein schalterseitiges Ende (4) sich in der Ruhestellung in unmittelbarer Nähe der aktiven Fläche (7) des Näherungsschalters (1) befindet.

3. Pedal mit berührungslosem Pedalschalter nach Anspruch 1 oder 2,
**dadurch gekennzeichnet, daß**
der Stift mittels einer in radialer Richtung wirkenden Feder (6) verschiebbar und justierbar gelagert ist.

4. Pedal mit berührungslosem Pedalschalter nach Anspruch 3,
**dadurch gekennzeichnet,**
**daß** der Stift (3) mindestens über einen Teil seiner Länge eine Rändelung (8) aufweist und daß die Feder als in die V-förmig ausgebildeten Nuten der Rändelung (8) drückende Omega-Feder (6) ausgebildet ist.

## Claims

1. Pedal with contactless pedal switch with a fixed proximity switch (1) and with a ferromagnetic pin (3) arranged on the pedal (2) so as to be substantially parallel to the actuation direction thereof and which moves with the pedal in the axial direction, the switch-side end (4) of which pin extends into the active switching region (5) of the proximity switch (1) in the rest position of the pedal (2) and can be withdrawn from the switching region (5) by actuation of the pedal (2), the pin (3) being mounted axially displaceably in the pedal (2) for the purpose of self-adjustment.

2. Pedal with contactless pedal switch according to claim 1, **characterised in that** the pin (3) is moved and adjusted to such an extent that its switch-side end (4) is located in the immediate vicinity of the active face (7) of the proximity switch (1) in the rest position.

3. Pedal with contactless pedal switch according to claim 1 or 2, **characterised in that** the pin is moveably and adjustably mounted by means of a spring (6) acting in the radial direction.

4. Pedal with contactless pedal switch according to claim 3, **characterised in that** the pin (3) has knurling (8) over at least a portion of its length and **in that** the spring is designed as an omega spring (6) which presses into the V-shaped grooves of the knurling (8).

## Revendications

1. Pédale comportant un interrupteur de pédale sans contact avec un interrupteur de proximité à agencement fixe (1) et une goupille ferromagnétique (3) agencée sur la pédale (2), pour l'essentiel parallèlement à sa direction d'actionnement, se déplaçant dans la direction axiale avec la pédale, dont l'extrémité du côté de l'interrupteur (4) pénètre dans la position de repos de la pédale (2) dans la zone de commutation active (5) de l'interrupteur de proximité (1) et pouvant être déplacée hors de la zone de commutation (5) par actionnement de la pédale (2), la goupille (3) étant agencée dans la pédale (2) de sorte à pouvoir être déplacée axialement en vue d'assurer un auto-ajustement.

2. Pédale comportant un interrupteur de pédale sans contact selon la revendication 1, **caractérisée en ce que** la goupille (3) est déplacée et ajustée de sorte que son extrémité du côté de l'interrupteur (4) se trouve dans la position de repos à proximité immédiate de la surface active (7) de l'interrupteur de proximité (1).

3. Pédale comportant un interrupteur de pédale sans contact selon les revendications 1 ou 2, **caractérisée en ce que** la goupille est agencée de sorte à pouvoir être déplacée et ajustée par un ressort (6) agissant dans la direction radiale.

4. Pédale comportant un interrupteur de pédale selon la revendicaiton 3, **caractérisée en ce que** la goupille (3) comporte un moletage (8), du moins sur une partie de sa longueur, le ressort ayant la forme d'un ressort oméga (6) exerçant une poussée dans les rainures en V du moletage (8).
